# EUROPEAN PATENT SPECIFICATION

(11) **EP 2 242 084 B1**
(45) Date of publication and mention of the grant of the patent: **07.10.2015**
(21) Application number: 08722768.2
(22) Date of filing: 25.03.2008
(51) Int. Cl.: H01J 1/16, H01J 1/304, H01J 9/02, H01J 9/04, H01J 37/073

(54) **METHOD OF MANUFACTURING AN ELECTRON SOURCE**
HERSTELLUNGSVERFAHREN EINER ELEKTRONENQUELLE
PROCÉDÉ DE FABRICATION D'UNE SOURCE D'ÉLECTRONS

(30) Priority: 07.02.2008 JP 2008027796
(43) Date of publication of application: 20.10.2010
(73) Proprietor: Denki Kagaku Kogyo Kabushiki Kaisha, Tokyo 103-8338 (JP)
(72) Inventor: NAKAHARA, Fumihiro, Gunma 377-8520 (JP); NONOGAKI, Ryozo, Gunma 377-8520 (JP); TERUI, Yoshinori, Gunma 377-8520 (JP)
(74) Representative: Blodig, Wolfgang
(86) International application number: PCT/JP2008/055558
(87) International publication number: WO 2009/098788

(56) References cited:
- EP-A1- 1 596 418
- EP-A1- 1 858 047
- WO-A1-2004/073010
- WO-A1-2006/075715
- JP-A- 10 084 020
- JP-A- 59 011 631
- JP-A- 2000 338 020
- JP-A- 2004 179 038
- JP-A- 2005 302 265
- JP-A- 2008 177 017
- US-A1- 2004 134 418
- US-A1- 2005 232 120
- US-B1- 6 403 958

## Description

### TECHNICAL FIELD

The present invention relates to a manufacturing method of an electron source.

### BACKGROUND ART

In recent years, electron guns using cathodes with monocrystalline tungsten needle electrodes (electron sources (hereinafter referred to as ZrO/W electron sources)) having coating layers of zirconium and oxygen (hereinafter referred to as ZrO/W electron guns) have been used to obtain electron beams that are brighter and have a longer operating life than hot cathodes (see Non-Patent Document 1).

ZrO/W electron guns are obtained by providing a diffusion layer consisting of zirconium and oxygen (hereinafter referred to as a ZrO coating layer) on a needle cathode composed of tungsten monocrystals having an axial orientation in the <100> orientation. This ZrO coating layer reduces the work function of the (100) plane of the tungsten monocrystals from 4.5 eV to about 2.8 eV, so that only the small crystalline facet corresponding to the (100) plane formed at the tip of this cathode forms an electron emission region, as a result of which an electron beam that is brighter than that of conventional hot cathodes can be obtained, and the operating life is also prolonged. Additionally, they have the advantages of being more stable than cold field-emission electron guns, operating in a lower vacuum, and being easy to use (see Non-Patent Document 2).

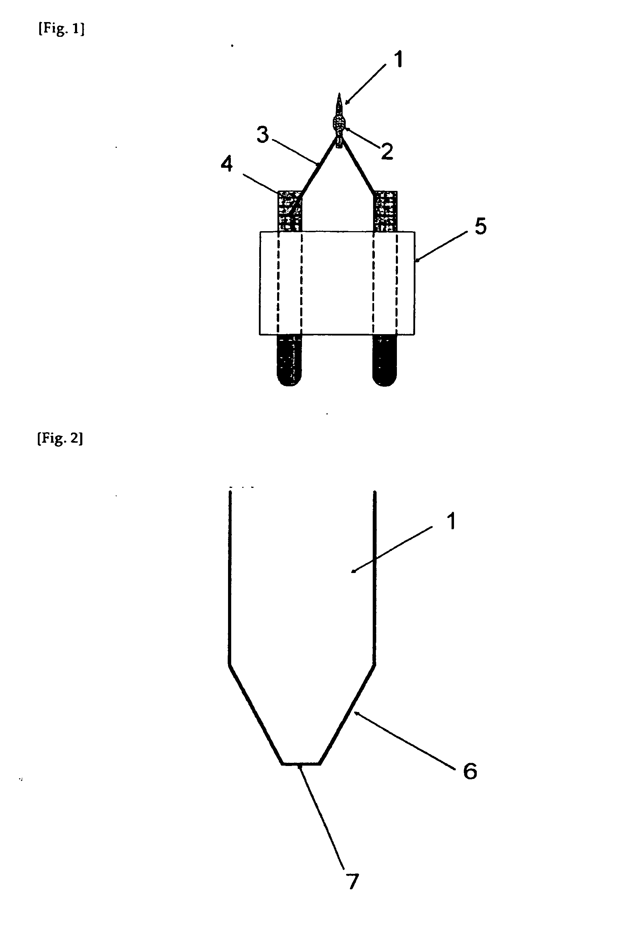

As shown in Fig.1, a ZrO/W electron gun comprises a needle cathode 1 of tungsten in the <100> orientation for emitting an electron beam attached by welding or the like to a portion of a tungsten filament 3 provided on a conductive terminal 4 anchored to an insulator 5. A reservoir 2 of zirconium and oxygen is formed in a portion of the cathode 1. While not shown in the drawings, the surface of the cathode 1 is covered with a ZrO coating layer.

Since the cathode 1 is electrically heated to about 1800 K by means of the filament 3, the ZrO coating layer on the surface of the cathode 1 will evaporate. However, zirconium and oxygen are continuously supplied to the surface of the cathode 1 by diffusion from the reservoir 2, so the ZrO coating layer is maintained.

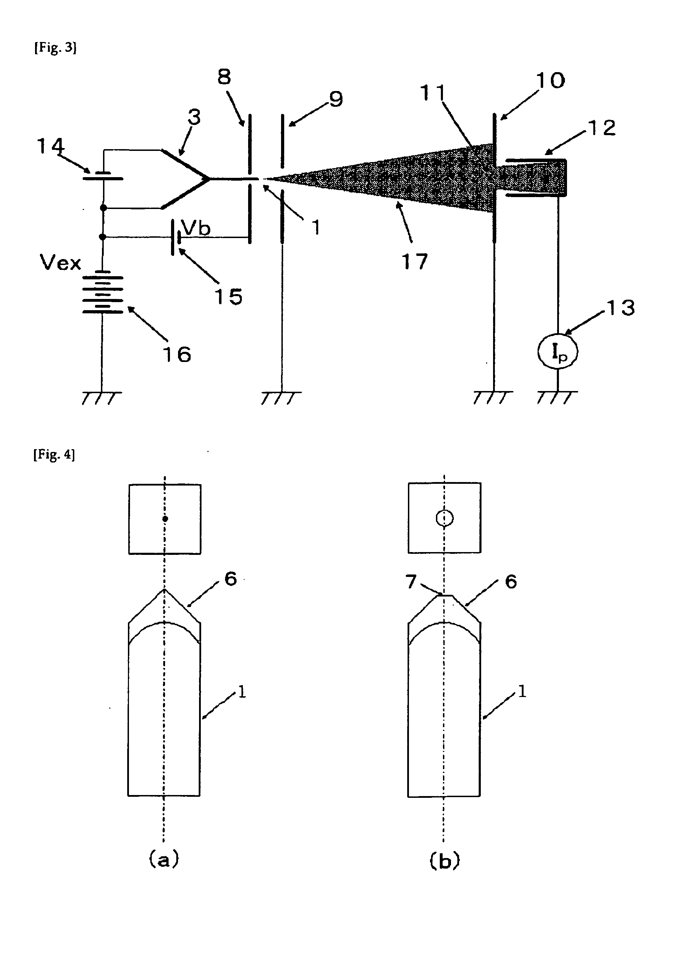

The tip portion of the cathode 1 of the ZrO/W electron gun is positioned between the suppressor electrode 8 and the extractor electrode 9 for use (see Fig. 3). A high negative voltage is applied between the extractor electrode 9 and the cathode 1, while a negative voltage of a few hundred volts is applied between the cathode 1 and the suppressor electrode 8, to suppress thermal electrons issuing from the filament 3.

In critical dimension SEM and wafer inspection equipment where they are used at low accelerating voltages, ZrO/W electron guns are operated at an angular current density of 0.1-0.2 mA/sr, where the probe current is stable and broadening of the energy width can be suppressed.

On the other hand, in electron beam lithography and Auger spectroscopy devices, they are operated at a high angular current density of about 0.4 mA/sr due to the emphasis on throughput. In such applications emphasizing throughput, operation at even higher angular current densities is desired, and angular current densities as high as 1.0 mA/sr are sometimes called for.

However, in ZrO/W electron guns, there is still room for improvement in that (1) angular current densities of about 1.0 mA/sr are the upper limit for operating at high angular current densities, and (2) at such times, the extraction voltage applied between the cathode and the extractor electrode can be greater than 4 kV, resulting in an extremely high field intensity of 0.4 to 1.0 × 10⁹ V/m at the tip, which increases the frequency of damage due to arc discharge (see Non-Patent Document 3).

In order to overcome these drawbacks, an electron gun wherein the cathode tip portion of the ZrO/W electron gun has a truncated conical shape, with the diameter of the top surface of the truncated cone forming the electron emission portion being at least 5 µm and at most 200 µm, so as to enlarge the electron emission area and enable operation at a high angular current density with a low extraction voltage has been proposed (see Patent Document 1). According to an embodiment of this Patent Document 1, the cathode tip portion is formed into a cone, then the cathode tip portion is shaped to a truncated cone by mechanical polishing. Additionally, Patent Document 1 also proposes a method in which the cathode tip portion is formed into a cone, then carved flat by a focused gallium ion beam to form a truncated cone.

However, in electron guns having cathode tip portions that are formed into truncated cones by mechanical polishing, the emission current density can become uneven. This unevenness can cause deviations in the axial current, making uniform electron beam emissions difficult. This unevenness is attributed to processing surface scars caused by machining of the monocrystalline rod. While the depth of the processing scar layer depends on the roughness of the abrasive grains used for machining and mechanical polishing, they are known to extend as deep as tens of microns (see Non-Patent Document 4).

As a solution for these problems, a method of improving the uniformity of the current emission distribution by processing the cathode tip portions into truncated cones by mechanical polishing, then removing the processing scar layer by electrolytic polishing has been proposed (see Patent Document 2). An example from Patent Document 2 demonstrates the effects of improving uniformity of the current emission distribution when providing a flattened portion with a diameter of 20 µm. The most relevant documents cited in the European search report are EP1 596 418 A1 and EP1 858 047 A1. Both references relate to a method of manufacturing an electron source with a truncated cone shaped cathode.
Patent Document 1: WO 2004/073010 (EP 1 596 418 A1)
Patent Document 2: WO 2006/075715 (EP 1 858 047 A1)
Non-Patent Document 1: D. Tuggle, J. Vac. Sci. Technol., 1979, 16, p. 1699.
Non-Patent Document 2: M. J. Fransen, "On the Electron-Optical Properties of the ZrO/W Schottky Electron Emitter", Advances in Imaging and Electron Physics, Academic Press, 1999, Vol. III, pp. 91-166.
Non-Patent Document 3: D. W. Tuggle, J. Vac. Sci. Technol., 1985, B3(1), p. 220.
Non-Patent Document 4: U. Linke and W. U. Kopp, "Surface Analysis by X-ray Topography and Etching During the Preparation of Single Crystal Surfaces", Microstructural Sciences, 1981, Vol. 9, pp. 299-308.

### DISCLOSURE OF THE INVENTION

### Problems to be Solved by the Invention

However, the conventional art described in the above literature has the potential for improvement on the following points.

First, while Patent Document 1 also proposes a method of shaping the cathode tip portion into a cone, then carving flat with a focused gallium ion beam to form a truncated cone, the embodiments only describe a method of shaping the cathode tip portion into a cone, then mechanically polishing to provide a flattened portion with a diameter of 100 µm at the cathode tip portion, thereby resulting in a truncated cone.

By shaping the cathode tip portion into a cone, then carving flat with a focused gallium ion beam to form a truncated cone, it is indeed likely to be possible to obtain an electron emission surface with a reduced scar layer, thereby resulting in a uniform emission current density as described in Patent Document 1. However, since the processing speed of a focused gallium ion beam is extremely slow, several hours may be required to form a flattened surface with a diameter of about 5 µm from a conical cathode tip portion, and when considering that in practice, it must be applied to a manufacturing process on a production line, a flattened surface with a diameter of 10 µm or more would be very difficult to form by means of a focused gallium ion beam.

Secondly, Patent Document 2 discloses a method of forming the cathode tip portion into a truncated cone by means of mechanical polishing, then removing the work scar layer by means of electrolytic polishing, and the examples demonstrate effects of improving non-uniformity of the current emission distribution when providing a flattened portion with a diameter of 20 µm.

However, with this method, the electrolytic polishing results in sagging at the outer periphery of the electron emission surface, so when the diameter of the top surface of the truncated cone forming the electron emission surface is small, the electron emission surface can become curved, thereby reducing the emission current density.

In other words, as described above, the present inventors have developed techniques for solving the respective technical demands for (1) efficiently forming an electron emission surface with a reduced scar layer in a short time in an electron source, (2) improving the non-uniformity of current emission distribution, and (3) increasing the emission current density. However, the present inventors found, based on a number of discoveries as described above, that these techniques are not capable of achieving a good balance among these three technical demands which have a conflicting relationship.

The fact that these three technical demands conflict with each other in this way was discovered by the present inventors when they observed, during the process of further improving the technology of Patent Document 1, that the processing speed of the focused gallium ion beam was extremely slow, with several hours being necessary to form a flattened surface with a diameter of about 5 µm from a conical cathode tip portion, and observed, during the process of further improving the technology of Patent Document 2, that electrolytic polishing causes sagging at the outer periphery of the electron emission surface, so that if the diameter of the top surface of the truncated cone forming the electron emission surface is small, the electron emission surface becomes curved, thus reducing the emission current density.

The present invention is based on the above-described technical problem which was recognized for the first time in the relevant technical field, and has the object of offering a technique that achieves a good balance between three technical demands which have a conflicting relationship, the demands being those of (1) efficiently forming an electron emission surface with a reduced scar layer in a short time in an electron source, (2) improving the uniformity of current emission distribution, and (3) increasing the emission current density.

### Means for Solving the Problems

The present invention offers a method of manufacturing an electron source having an electron emission portion at one tip portion of a rod, the method of manufacturing the electron source comprising a step of forming the tip portion in the shape of a truncated cone having a flattened top surface by a machining process, a step of removing a surface layer of the flattened top surface by focused ion beam processing, and between the step of forming the tip portion in the shape of a truncated cone and the step of removing a surface layer of the flattened top surface by focused ion beam processing, a step of removing a processing scar layer on the surface of said tip portion by means of vapor phase etching or electrolytic polishing.

Thus, this method is capable of efficiently forming an electron emission surface with a reduced scar layer and little sagging at the outer periphery in a short period of time, thus achieving a good balance between three technical demands which have a conflicting relationship, the three demands being those of (1) efficiently forming an electron emission surface with a reduced scar layer in a short time in an electron source, (2) improving the uniformity of current emission distribution, and (3) increasing the emission current density.

### Effects of the Invention

The present invention achieves a good balance between three technical demands which have a conflicting relationship, the three demands being those of (1) efficiently forming an electron emission surface with a reduced scar layer in a short time in an electron source, (2) improving the uniformity of current emission distribution, and (3) increasing the emission current density.

### BRIEF DESCRIPTION OF THE DRAWINGS

[Fig. 1] A view showing the structure of a ZrO/W electron gun.
[Fig. 2] An enlarged view of a cathode.
[Fig. 3] A view showing the constitution of a device for evaluating electron emission properties.
[Fig. 4] Fig. 4(a) is a view for explaining a comparative example of a rod 1, and Fig. 4(b) is a view for explaining an embodiment of the rod 1.
[Fig. 5] A graph showing the results of measurements of the current emission distribution (Example 1 and Comparative Example 1).
[Fig. 6] A graph showing the current emission distribution in Example 2.
[Fig. 7] A graph showing the current emission distribution in Comparative Example 2.

### Description of the Reference Numbers

- 1: cathode
- 2: reservoir
- 3: filament
- 4: conductive terminal
- 5: insulator
- 6: conical portion (of truncated conical portion)
- 7: flattened portion (top surface portion of truncated conical portion)
- 8: suppressor electrode
- 9: extractor electrode
- 10: phosphor screen
- 11: aperture
- 12: cup-shaped electrode
- 13: probe current measuring microcurrent meter
- 14: filament-heating power source
- 15: bias power source
- 16: high voltage power source
- 17: emitted electron beam

### BEST MODES FOR CARRYING OUT THE INVENTION

### <Explanation of Terminology>

The terminology used in the present specification and claims are defined as below.

### (Lower limit value) to (upper limit value): Means at least the lower limit value and at most the upper limit value.

Hot cathode field emission type electron gun: Refers to an electron gun of the type in which an emitter is heated in an electric field to induce emission of electrons. The most common types have conventionally been those in which a tungsten chip is heated to about 2600 K to cause the electrons to jump across the potential barrier (about 4.5 eV) to be emitted, but recently, those in which an emitter formed by coating zirconium oxide to lower the potential barrier (about 2.7 eV) is heated to about 1800 K and using the Schottky effect to emit electrons have become more common.

Etching: Refers to a method used in the fabrication of samples of semiconductors and inorganic compounds, wherein surface atoms are selectively removed from the surface of a solid by means of chemical or physical reactions. They can be classified as either liquid phase etching or vapor phase etching.

Chemical polishing: Refers to a method used for fabricating samples of semiconductors and inorganic compounds. The sample is immersed in a polishing solution based on a strong acid or strong alkali, to form a thin film while keeping the sample surface smooth. The advantage is that a sample can be fabricated without applying any mechanical strain. In the present specification and claims, it refers to methods using a polishing solution or the like such that selective dissolution (etching) does not occur.

Mechanical polishing: Refers to physical polishing of a sample. Examples include manual polishing using waterproof paper, polishing with diamond powder or corundum using a rotating polisher, polishing with corundum powder using a dimple grinder, and polishing with diamond powder using a tripod polisher.

Electrolytic polishing: Refers to a method used for working materials such as metals and alloys, in which they are immersed in an appropriate electrolytic solution, and a DC current is applied with the sample as the anode and platinum or stainless steel as the cathode to cause elution of the material surface, so as to polish the sample surface while keeping it smooth. The advantage is that the material can be worked without applying any mechanical strain.

Focused ion beam processing: Refers to a methods of processing a sample by accelerating ions such as gallium ions to about a few kV to 40 kV and focusing them on the sample. In some cases, the sample can be processed while observing local areas by secondary ion images (in some devices, a SEM image can be seen).

### <Embodiment 1>

Herebelow, a specific embodiment of the present invention shall be described with reference to Fig. 1 to Fig. 4.

The present embodiment will describe a method of manufacturing an electron source used in an electron gun for electron beam appliances such as scanning electron microscopes, Auger electron spectroscopes, electron beam lithography devices and wafer inspection devices, the electron gun being especially appropriate for use in electron beam lithography.

The present embodiment is a method of manufacturing an electron source having an electron emission portion at one tip portion of a rod-shaped cathode 1, the method of manufacturing an electron source comprising a step of forming the tip portion into a conical portion 6 by a machining process, then forming into the shape of a truncated cone having a flattened portion 7, and a step of removing a surface layer of the flattened portion 7 by focused ion beam processing.

In the method of the present embodiment, a tip portion of a rod-shaped cathode 1 of a tungsten or molybdenum monocrystal in the <100> orientation is provided with a conical portion 6 by mechanical polishing or electrolytic polishing, then a flattened portion 7 is formed on the vertex by mechanical polishing using a polishing film or the like covered with a diamond polishing agent.

In order to obtain an electron source with a low total emission current even during operation at high angular current densities which is appropriate for use in an electron beam lithography device or an Auger electron spectroscopy device, the total angle of the conical portion 6 should be at least 25° and at most 95°, and the diameter of the flattened portion 7 should be 5 to 200 µm. Furthermore, for similar reasons, the line normal to the flattened electron emission surface formed on the tip portion of the cathode should be within 2° of the <100> direction, and should more preferably be contained within an angular difference of 0.5°.

The cathode 1 is affixed by welding via tungsten filaments 3 to a conductive terminal 4 brazed to an insulator 5, and can be electrically heated.

While the processing scar layer of the flattened portion 7 of the cathode 1 will ultimately be removed by a focused gallium ion beam, if the cut surface is initially too rough, a focused gallium ion beam may not be sufficient to remove the processing scar layer. Therefore, after forming the flattened portion 7, the processing scar layer is removed by vapor phase etching or electrolytic polishing. In other words, between the above-described step of forming the tip portion into a conical portion 6 by a machining process, then forming into the shape of a truncated cone having a flattened portion 7 (flattened surface), and the step of removing a surface layer of the flattened portion 7 by focused ion beam processing, a step of removing the processing scar layer on the surface of the tip portion by vapor phase etching or electrolytic polishing is included.

The vapor phase etching method may, for example, be performed by evacuating a vacuum device, feeding oxygen gas into the device to a pressure of 3 × 10⁻⁶ Torr (4 × 10⁻⁴ Pa), and heating the cathode 1 to a temperature of 1800 K to 2000 K. Additionally, the chemical etching method may, for example, be performed by immersing the conical portion 8 of the cathode 1 in 1 mol/L aqueous solution of sodium hydroxide, and applying a voltage of 6 V between the conductive terminal 4 and an electrode provided in the solution.

While these methods of removing the processing scar layer can result in irregularities being formed or curvature of the flattened portion 7 (due to sagging at the outer periphery), in the present embodiment, they will have practically no effect on the electron emission properties because they will be ultimately re-flattened by a focused gallium ion beam.

The cathode 1 is provided with a reservoir consisting of oxygen and a metal having the effect of reducing the work function of the electron emission surface. In particular, electron sources having a reservoir consisting of metal oxides comprising elements chosen from the group consisting of zirconium (Zr), titanium (Ti), hafnium (Hf), scandium (Sc), yttrium (Y), the lanthanoids, barium (Ba), strontium (Sr) and calcium (Ca) can be appropriately applied as an electron source for hot cathode field emission type electron guns.

Using Zr-O as an example, a reservoir of zirconium and oxygen can be formed by crushing zirconium hydride and mixing with an organic solvent to form a paste, applying the paste to a portion of the cathode, heating the cathode in an oxygen atmosphere of about 3 × 10⁻⁶ Torr (4 × 10⁻⁴ Pa) to thermally decompose the ZrHz, and further oxidizing.

Even with such heat treatments in an oxygen atmosphere, the cathode 1 can be etched by the oxygen so as to form irregularities on the flattened portion 7, but in this case as well, it will be re-flattened by means of a focused gallium ion beam, and therefore will not affect the electron emission properties.

When re-flattening the flattened portion 7 by means of the focused gallium ion beam, the flattened portion 7 is positioned so as to be parallel to the direction of the ion beam, and the ion beam is uniformly emitted in a manner limited to the surface layer of the flattened portion 7, thereby enabling a surface with a high degree of flatness with no processing scars to be formed in a short time. At this time, the surface layer of the flattened portion 7 should preferably be removed by shining a focused gallium ion beam in a xenon difluoride atmosphere in view of the efficiency of removal of the surface layer of the flattened portion 7.

This cathode is positioned between the extractor electrode 9 and the suppressor electrode 8, and a high negative voltage of several kilovolts is applied between the extractor electrode 9 and the cathode 1. Additionally, a negative voltage of a few hundred volts is applied between the suppressor electrode 8 and the cathode 1, and the cathode 1 is heated to 1500 K to 1900 K so as to induce electron emissions.

According to the method of the present embodiment, the electron emission surface is processed by a focused gallium ion beam to remove a processing scar layer caused by mechanical polishing, thereby resulting in a uniform emission current density. As a consequence, as shall be described in an example below, a hot cathode field emission type electron gun comprising the electron source of the present embodiment achieves a uniform emission current density at high angular current densities of 1 mA/sr or more, with an extremely low excess current, making it highly reliable. Furthermore, this electron gun operates in a vacuum of 1 × 10⁻⁸ Torr (1 × 10⁻⁶ Pa) or less and is tungsten-based, as a result of which the cathode undergoes very little erosion and will have few changes in properties even when operated over a long period of time, and the cathode surface can be quickly repaired to a smooth surface even after being battered by ion collisions.

### <Functions and Effects of Embodiment 1>

Herebelow, the functions and effects of the method of manufacturing an electron source according to the present embodiment shall be explained.

The present embodiment offers a method of manufacturing an electron source having an electron emission portion at one tip portion of the cathode 1 (rod), the method of manufacturing an electron source comprising a step of forming the tip portion into the shape of a truncated cone having a flattened portion 7 (flattened surface), and a step of removing a surface layer of the flattened portion 7 by focused ion beam processing.

According to this method, the tip portion is formed into the shape of a truncated cone having a flattened portion 7 by means of a machining process capable of efficiently forming the electron emission surface in a short period of time, then the surface layer of the flattened portion 7 is removed by focused ion beam processing so as to form an electron emission surface with a reduced scar layer.

As a result, the method of the present embodiment enables a flattened portion 7 (electron emission surface) with a reduced scar layer and little sagging at the outer periphery to be efficiently formed in a short period of time, thus achieving a good balance between three technical demands which have a conflicting relationship, the three demands being those of (1) efficiently forming an electron emission surface with a reduced scar layer in a short time in an electron source, (2) improving the uniformity of current emission distribution, and (3) increasing the emission current density.

Furthermore, the method of the present embodiment further includes a step of removing the processing scar layer on the surface of the tip portion by vapor phase etching or electrolytic polishing, between the above-described step of forming into the shape of a truncated cone and the above-described step of removing the surface layer of the flattened portion 7 (flattened surface). By doing so, even if the surface achieved by the initial mechanical polish is too rough, the processing scar layer on the surface of the tip portion can be removed to some degree by liquid phase etching or electrolytic polishing, so the processing scar layer of the flattened portion 7 of the cathode 1 can be finally removed by the focused gallium ion beam.

Additionally, in the method of the present embodiment, the above-mentioned step of removing the surface layer of the flattened portion 7 (flattened surface) should preferably be a step of removing the surface layer of the flattened surface by irradiating with a focused gallium ion beam in a xenon difluoride gas atmosphere. By doing so, the efficiency of removing the surface layer of the flattened portion 7 by means of the focused gallium ion beam can be improved, and a flattened portion 7 with a high degree of flatness and few processing scars can be formed in an even shorter period of time.

Furthermore, in the method of the present embodiment, the diameter of the above-mentioned flattened portion 7 (flattened surface) should preferably be at least 10 µm and at most 100 µm. In this manner, an electron source with a low total emission current even when operating at high angular current densities which is appropriate for use in electron beam lithography devices and Auger spectroscopy devices can be obtained.

According to the present embodiment, sagging at the outer periphery of the electron emission surface can be suppressed even if the diameter of the flattened portion 7 is as small as 10 µm, thereby preventing the electron emission surface from becoming curved and reducing the emission current density. On the other hand, according to the method of the present embodiment, an electron emission surface with a reduced scar layer can be formed in a short time by using a focused gallium ion beam, even if the diameter of the flattened portion 7 is as large as 100 µm.

In the method of the present embodiment, the above-mentioned electron source is preferably an electron source provided with a reservoir for diffusion of oxides of metal elements to a monocrystalline rod (cathode 1) of tungsten or molybdenum. Additionally, the metal element should preferably be a metal element chosen from among Ca, Sr, Ba, Sc, Y, La, Ti, Zr, Hf and the lanthanoids. Furthermore, the orientation of the above-mentioned rod (cathode 1) should preferably be <100>. Additionally, the above-mentioned electron source should preferably be an electron source for a hot cathode field emission type electron gun.

In this manner, the work function of the tungsten monocrystal <100> can be largely reduced from 4.5 eV by the coating layer of these metal oxides, and the electron emission region will be constituted by only the small crystal facet corresponding to the flattened portion 7 formed on the tip portion of the cathode, so when used as an electron source for a hot cathode field emission type electron gun, it has the advantages of providing an electron beam that is brighter than those of conventional hot cathodes, and also prolonging the lifespan. Additionally, the electron gun has the advantages of being more stable than cold field emission type electron guns, being capable of operating in a low vacuum, and being easy to use.

### <Embodiment 2>

Herebelow, another embodiment not forming part of the present invention shall be explained with reference to Fig. 1 to Fig. 4, with an emphasis on the features differing from Embodiment 1. In all of the drawings, the same reference numbers are used to designate elements that are the same as those in Embodiment 1, and their explanations will be omitted.

The present embodiment, as in the case of Embodiment 1, is a method of manufacturing an electron source having an electron emission portion at one tip portion of a cathode 1 (rod), the method of manufacturing an electron source comprising a step of forming the tip portion into the shape of a truncated cone having a flattened portion 7 by a machining process, and a step of removing a surface layer of the flattened portion 7 by vapor phase etching. In the present embodiment, formation of the electron emission portion by machining is followed by vapor phase etching of the electron emission portion, thereby enabling the current emission distribution to be made more uniform, and offering a large-current electron source.

The gas used for vapor phase etching in the present embodiment should preferably be oxygen due to its etching efficiency and improved precision, the oxygen pressure should preferably be 0.3 × 10⁴ to 8 × 10⁻⁴ Pa, and the temperature should preferably be at least 1700 K and at most 1950 K. For the same reasons as Embodiment 1, the rod in the present embodiment should preferably have a reservoir of oxides of metal elements chosen from the group consisting of Ca, Sr, Ba, Sc, Y, La, Ti, Zr, Hf and the lanthanoids.

Regarding the method of manufacturing this reservoir, a description shall be given for the case of zirconium oxide. In order to manufacture a reservoir formed of zirconium oxide, zirconium hydride is first crushed and mixed with isoamyl acetate to form a paste which is then applied to a portion of the monocrystalline rod constituting the cathode 1. Next, after the isoamyl acetate has evaporated, it is placed in an ultrahigh vacuum device. Next, the device is evacuated to an ultrahigh vacuum of 3 × 10⁻¹⁰ Torr (4 × 10⁻⁸ Pa) and electricity is passed through the filament 3 to heat the monocrystalline rod 1 to 1800 K, so as to thermally decompose the zirconium hydride and form metallic zirconium. Next, oxygen gas is fed into the device to a pressure of 3 × 10⁻⁶ Torr (4 × 10⁻⁴ Pa) so as to oxidize the metallic zirconium, resulting in a reservoir consisting of zirconium oxide.

Here, the orientation of the rod constituting the cathode 1 should preferably be in the <100> direction for the same reasons as Embodiment 1.

Additionally, the rod constituting the cathode 1 of the present embodiment has a conical portion 6 on a tip portion, with an electron emission portion at the vertex thereof, this electron emission portion being shaped flat, and for the same reasons as Embodiment 1, the diameter of the flattened portion 7 should be at least 10 µm and at most 100 µm, and more preferably at least 10 µm and at most 70 µm. Furthermore, in the electron source of the present embodiment, the rod constituting the cathode 1 has a conical portion 6 at a tip portion, and for the same reason as in Embodiment 1, a flattened electron emission portion should be formed on the vertex of the conical portion 6 after removing the processing scar layer by chemical etching.

On the other hand, it is not always necessary to perform chemical etching, and in a method of manufacturing an electron source having an electron emission portion on a tip portion of a rod consisting of a monocrystal of tungsten or molybdenum constituting the cathode 1, the electron emission portion can be subjected to vapor phase etching after the electron emission portion has been formed by machining.

To repeat, the gas used in vapor phase etching of the present embodiment should preferably be oxygen for its etching efficiency and improved precision, preferably at an oxygen pressure of 0.3 × 10⁻⁴ to 8 × 10⁻⁴ Pa and a temperature of at least 1700 K and at most 1950 K. The rod constituting the cathode 1 in the present embodiment should preferably have a reservoir of an oxide of a metal element chosen from among Ca, Sr, Ba, Sc, Y, La, Ti, Zr, Hf and the lanthanoids for the same reason as Embodiment 1. The orientation of the rod constituting the cathode 1 in the present embodiment should preferably be in the <100> direction for the same reason as in Embodiment 1.

Additionally, the rod constituting the cathode 1 of the present embodiment has a conical portion 6 on a tip portion, with an electron emission portion at the vertex thereof, this electron emission portion being shaped flat, and for the same reasons as Embodiment 1, the diameter of the flattened portion 7 should be at least 10 µm and at most 100 µm, and more preferably at least 10 µm and at most 70 µm. Furthermore, in the electron source of the present embodiment, the rod constituting the cathode 1 has a conical portion 6 at a tip portion, and for the same reason as in Embodiment 1, a flattened electron emission portion should be formed on the vertex of the conical portion 6 after removing the processing scar layer by chemical etching.

In this case, the etching of the surface of the rod constituting the cathode 1 can be performed by welding the rod constituting the cathode 1 to a filament, placing it in an ultrahigh vacuum (3 × 10⁻¹⁰ Torr (4 × 10⁻⁸ Pa)), then feeding oxygen gas into the device to a pressure of 3 × 10⁻⁶ Torr (4 × 10⁻⁴ Pa) and heating to a temperature of 1800 K to 2000 K. By etching the monocrystalline surface in this way, it is possible to remove machining scars formed when shaping the rod constituting the cathode 1 into a cone.

The rod functions as a cathode, and its surface may be coated with oxygen and an oxide of a metal element chosen from among Ca, Sr, Ba, Sc, Y, La, Ti, Zr, Hf and the lanthanoids. Using Zr-O as an example, zirconium hydride is crushed and mixed with an organic solvent to form a paste which is applied to a portion of the cathode, and the cathode is heated in an oxygen atmosphere of about 1 × 10⁻⁶ Torr to thermally decompose the ZrH₂, and further oxidized to form a reservoir of zirconium and oxygen and coat the surface of the cathode with zirconium and oxygen. This cathode is placed between the extractor electrode and the suppressor electrode, a high negative voltage of several kV (kilovolts) is applied between the extractor electrode and the cathode, and a negative voltage of a few hundred kV is applied between the suppressor electrode 6 and the cathode 1 while heating the cathode 1 to 1500 to 1900 K to induce electron emissions.

### <Functions and Effects of Embodiment 2>

Herebelow, functions and effects of the method of manufacturing an electron source of the present embodiment shall be described.

The present embodiment offers a method of manufacturing an electron source having an electron emission portion at one tip portion of the cathode 1 (rod), the method of manufacturing an electron source comprising a step of forming the tip portion into the shape of a truncated cone having a flattened portion 7 (flattened surface), and a step of removing a surface layer of the flattened portion 7 by vapor phase etching.

According to this method, the tip portion is formed into the shape of a truncated cone having a flattened portion 7 by means of a machining process capable of efficiently forming the electron emission surface in a short period of time, then the surface layer of the flattened portion 7 is removed by vapor phase etching so as to form an electron emission surface with a reduced scar layer. Additionally, according to this method, electrolytic polishing and liquid phase etching are not performed (or electrolytic polishing or liquid phase etching is performed before forming the flattened portion by machining), so sagging at the outer periphery of the electron emission surface can be suppressed.

As a result, the method of the present embodiment enables a flattened portion 7 (electron emission surface) with a reduced scar layer and little sagging at the outer periphery to be efficiently formed in a short period of time, thus achieving a good balance between three technical demands which have a conflicting relationship, the three demands being those of (1) efficiently forming an electron emission surface with a reduced scar layer in a short time in an electron source, (2) improving the non-uniformity of current emission distribution, and (3) increasing the emission current density.

Furthermore, the method of the present embodiment should preferably further include a step of removing the processing scar layer on the surface of the tip portion by liquid phase etching or electrolytic polishing, between the above-described step of forming into the shape of a truncated cone and the above-described step of removing the surface layer of the flattened portion 7 (flattened surface). By doing so, even if the surface achieved by the initial mechanical polish is too rough, the processing scar layer on the surface of the tip portion can be removed to some degree by liquid phase etching or electrolytic polishing. Thereafter, the flattened portion can be formed and the processing scar layer of the flattened portion 7 of the cathode removed by vapor phase etching.

Additionally, in the method of the present embodiment, the above-described step of removing the surface layer of the flattened portion 7 (flattened surface) should preferably be a step of removing the processing scar layer of the surface of the tip portion including the surface layer of the flattened portion 7 by performing vapor phase etching with an oxygen pressure of at least 0.3 × 10⁻⁴ Pa and at most 8 × 10⁻⁴ Pa and a temperature of at least 1700 K and at most 1950 K. By doing so, the efficiency of removal of the surface layer of the flattened portion 7 by vapor phase etching can be improved, and a flattened portion 7 with a high degree of flatness and few processing scars can be formed in a much shorter period of time.

Furthermore, in the method of the present embodiment, the diameter of the flattened portion 7 (flattened surface) should preferably be at least 10 µm and at most 100 µm. By doing so, an electron source with a low total emission current even during operation at a high angular current density which is appropriate for electron beam lithography devices or Auger spectroscopy devices can be obtained.

According to the present embodiment, sagging at the outer periphery of the electron emission surface can be suppressed even if the diameter of the flattened portion 7 is as small as 10 µm, thereby preventing the electron emission surface from becoming curved and reducing the emission current density. On the other hand, according to the method of the present embodiment, an electron emission surface with a reduced scar layer can be formed in a short time by vapor phase etching, even if the diameter of the flattened portion 7 is as large as 100 µm.

In the method of the present embodiment, the above-mentioned electron source is preferably an electron source provided with a reservoir for diffusion of oxides of metal elements to a monocrystalline rod (cathode 1) of tungsten or molybdenum. Additionally, the metal element should preferably be a metal element chosen from among Ca, Sr, Ba, Sc, Y, La, Ti, Zr, Hf and the lanthanoids. Furthermore, the orientation of the above-mentioned rod (cathode 1) should preferably be <100>. Additionally, the above-mentioned electron source should preferably be an electron source for a hot cathode field emission type electron gun.

In this manner, the work function of the tungsten monocrystal <100> can be largely reduced from 4.5 eV by the coating layer of these metal oxides, and the electron emission region will be constituted by only the small crystal facet corresponding to the flattened portion 7 formed on the tip portion of the cathode, so when used as an electron source for a hot cathode field emission type electron gun, it has the advantages of providing an electron beam that is brighter than those of conventional hot cathodes, and also prolonging the lifespan. Additionally, the electron gun has the advantages of being more stable than cold field emission type electron guns, being capable of operating in a low vacuum, and being easy to use.

While embodiments 1 of the present invention has been described above with reference to the drawings, it is merely an example of the present invention, and various other structures may be employed within the scope of the present invention defined by the appended claims.

### Examples

Herebelow, the present invention shall be further explained by means of examples, but the present invention is not to be construed as limited thereby.

### <Example 1>

Herebelow, Example 1 shall be explained with reference to Fig. 1 to Fig. 4.

A tungsten filament 3 was spot-welded to a conductive terminal 4 brazed to an insulator 5. A conical portion 6 with a total angle of 90° was formed at the end portion of the monocrystalline tungsten tip in the <100> direction, using diamond paste and a polishing platen, and worked to the shape of Fig. 4(a). Furthermore, the vertex portion of the conical portion 6 was polished with a polishing film coated with a diamond polishing agent, to form a flattened portion 7 with a diameter of 35 µm as shown in Fig. 4(b). This rod was attached to the filament 3 by spot welding. This rod functioned as a cathode 1.

Thereafter, the conical portion 6 of the cathode 1 was immersed in a 1 mol/L aqueous solution of sodium hydroxide, and a voltage of 6 V was applied for 10 seconds between the conductive terminal 4 and an electrode set up in the solution, so as to perform chemical etching.

Next, a paste formed by crushing zirconium hydride and mixing with isoamyl acetate was applied to a portion of the cathode 1. Then, after evaporation of the isoamyl acetate, it was placed in an ultrahigh vacuum device. Next, the device was set to an ultrahigh vacuum of 3 × 10⁻¹⁰ Torr (4 × 10⁻⁸ Pa), and electricity was passed through the filament 3 to heat the monocrystalline rod 1 to 1800 K, so as to thermally break down the zirconium hydride to form metallic zirconium. Subsequently, oxygen gas was fed until the device was pressurized to 3 × 10⁻⁶ Torr (4 × 10⁻⁴ Pa), thereby oxidizing the metallic zirconium and forming a diffusion supply 2 of zirconium and oxygen consisting of zirconium oxide.

Next, the rod was placed in a focused gallium ion beam device and oriented so as to make the flattened portion 7 parallel to the direction of the ion beam, then it was uniformly irradiated with an ion beam having an acceleration voltage of 30 kV and a beam current of 5 nA, limited to the surface layer of the flattened portion 7, thereby further removing about 2 µm of the flattened portion 7 for reflattening.

The tip of the resulting cathode 1 was positioned between the suppressor electrode 8 and the extractor electrode 9. The distance between the tip of the cathode 1 and the suppressor electrode 8 was 0.1 mm, the distance between the suppressor electrode 8 and the extractor electrode 9 was 0.8 mm, the hole diameter of the extractor electrode 9 was 0.8 mm and the hole diameter of the suppressor electrode was 0.6 mm.

Furthermore, the filament 3 was connected to a filament heating power source 14 and further connected to a high voltage power source 16, to apply a high negative voltage, i.e. an extractor voltage Vₑₓ, with respect to the extractor electrode 9. Additionally, a suppressor electrode 8 was connected to a bias power supply 15, and a negative bias voltage V_{b} was applied to the cathode 1 and the filament 3. This blocked the thermal electrons emitted from the filament 3. The electron beam 17 emitted from the tip of the cathode 1 passed through the hole in the extractor electrode 9 to reach a phosphor screen 10. There was an aperture 11 (hole) in the center of the phosphor screen 10, and the probe current Iₚ passing through to the cup-shaped electrode 12 was measured by a microcurrent meter 13. Defining the solid angle computed from the distance between the aperture 11 and the tip of the cathode 1, and the inner diameter of the aperture 11 as ω, the angular current density is Iₚ/ω. Additionally, the aperture 11 and the cup-shaped electrode 12 can be moved from outside the vacuum system, to measure the current emission distribution.

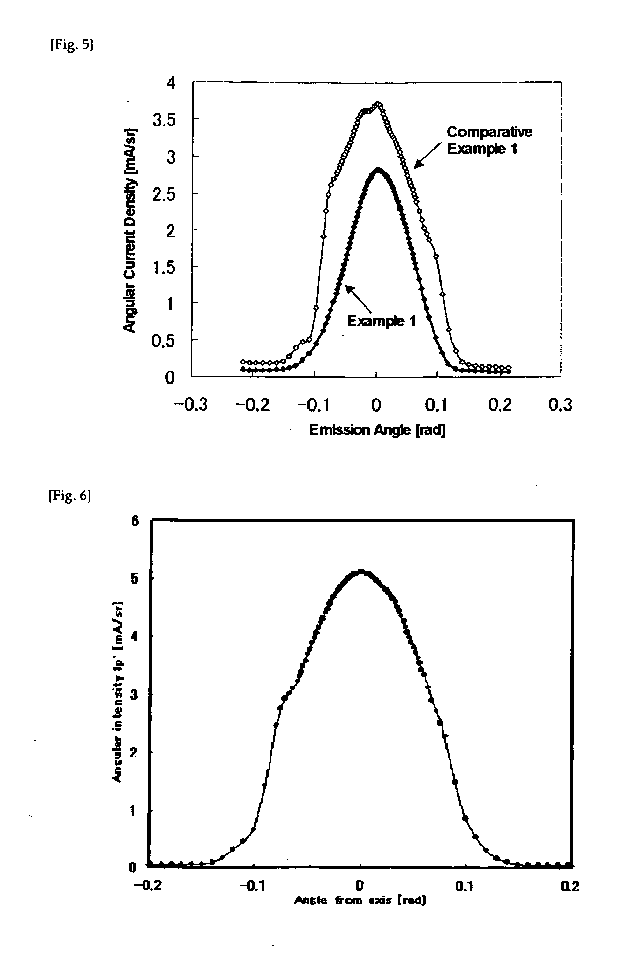

Further, the measuring device was set to an ultrahigh vacuum of 3 × 10⁻¹⁰ Torr (4 × 10⁻⁸ Pa), and a suppressor voltage V_{b} = -300 V with respect to the monocrystalline rod 1 was applied to the suppressor electrode 8 while keeping the monocrystalline rod 1 at 1800 K. Next, a high emitter voltage of Vₑₓ = -4000 V was applied to the monocrystalline rod 1 and held for several hours, and upon stabilization of the emission current, the change in the probe current Iₚ when moving the aperture 11 was measured, to determine the current emission distribution. The measurement results of this current emission distribution are shown in Fig. 5.

### <Comparative Example 1>

The current emission distribution of an electron gun produced by the same manufacturing method as Example 1, with the exception that flattening by chemical etching and focused gallium ion beam were not performed, was determined by the same method as the example. The measurement results of this current emission distribution are shown in Fig. 5.

### <Analysis of Results of Example 1 and Comparative Example 1>

While Fig. 5 shows the current emission distributions of Example 1 and Comparative Example 1 converted to angular current density, the comparative example can be observed to have an uneven distribution with non-uniformities, whereas the comparative example has a smooth and even distribution, as well as a high angular current density of at least 2 mA/sr.

In Example 1, a flattened portion 7 was provided at the vertex of the cathode 1 by mechanical polishing after forming a conical portion 6 by means of mechanical polishing of the tip of the cathode 1. Since mechanical polishing was used to form the tip of the cathode 1 into a truncated cone, the processing surface was scarred, but the processing scar layer was eliminated in a short time by a focused gallium ion beam and therefore easily removed.

That is, by first providing a flattened portion 7 by mechanical polishing and then processing with a focused gallium ion beam, an electron emission surface with a reduced scar layer was able to be efficiently formed in a short time. Furthermore, since it was processed by a focused gallium ion beam, sagging at the outer periphery of the electron emission surface which tends to occur when removing processing surface scars by liquid phase etching or the like was also prevented. As a result, Example 1 was able to achieve a uniform emission current density.

In other words, it was able to achieve a good balance between three technical demands which have a conflicting relationship, the demands being those of (1) efficiently forming an electron emission surface with a reduced scar layer in a short time in an electron source, (2) improving the non-uniformity of current emission distribution, and (3) increasing the emission current density.

### <Example 2>

Herebelow, Example 2 not forming part of the present invention, will be explained with reference to Figs. 1-4 and 6-7.

### (i) Electron Source

The electron source of the present example, as shown in Fig. 1, is formed by attaching a needle-shaped monocrystalline rod of tungsten in the <100> orientation emitting an electron beam by welding or the like at a predetermined position of a tungsten filament 3 provided on a conductive terminal 4 affixed to an insulator 5. This rod is a cathode 1 having a tip that is pointed by electrolytic polishing, and electrons are mainly emitted from this sharp tip. A reservoir 2 of zirconium and oxygen is provided in a portion of the rod constituting the cathode 1, and while not shown in the drawings, the surface of the rod constituting the cathode 1 is covered with a ZrO coating layer.

The tip portion of the rod constituting the cathode 1 is positioned between the suppressor electrode 8 and the extractor electrode 9 for use as shown in Fig. 3. A high negative voltage is applied between the rod, i.e. the cathode 1, and the extractor electrode 9, and a negative suppressor voltage of about a few hundred volts is applied between the suppressor electrode 8 and the monocrystalline rod, so as to suppress thermal electron emissions from the filament 3.

The rod tip portion constituting the cathode 1, as shown in Fig. 2, has a conical portion 6 formed by mechanical polishing the tip portion of a monocrystalline rod-shaped cathode 1 of tungsten or molybdenum monocrystals in the <100> orientation, and a flattened portion 7 formed by mechanical polishing of the vertex of the conical portion 6. The flattened portion 7 is also an electron emitting portion.

### (ii) Method of Producing Electron Source

The method of producing the electron source shall be explained with reference to Fig. 1.

As shown in Fig. 1, a tungsten filament 3 is attached by spot welding to a conductive terminal 4 brazed to an insulator 5.

After forming a rod constituting a cathode 1 of tungsten monocrystals in the <100> orientation, a rectangular parallelepiped of 2 mm × 0.4 mm × 0.4 mm is cut out by discharge processing, then one end is formed into a conical portion 6 with a total vertex angle of 90° using diamond paste and a polishing platen to achieve the shape of Fig. 4(a). The flattened portion 7 which is an electron emitting portion is formed by polishing with a polishing film coated with a chrome oxide polishing agent until the diameter of the circle at the vertex of the conical portion 6 is 40 µm as shown in Fig. 4(b).

This rod constituting a cathode 1 is attached to a filament 3 by laser welding (see Fig. 1). The rod functions as a cathode 1. The filament 3 is attached by welding to a conductive terminal 4 brazed to an insulator 5.

Subsequently, electricity is applied to the filament 3 in an oxygen atmosphere of 3 × 10⁻⁶ Torr (4 × 10⁻⁸ Pa), thereby etching the surface of the rod constituting the cathode 1.

The reservoir 2 shown in Fig. 1 was formed in a portion of the rod constituting the cathode 1. The reservoir 2 was formed by crushing a zirconium hydride powder and mixing with an organic solvent to form a slurry that was then applied to a portion of the rod constituting the cathode 1. After the isoamyl acetate evaporated, the rod was heated in an oxygen atmosphere of about 1 × 10⁻⁶ Torr to thermally decompose the hydrides, and further oxidized to result in zirconium oxide. Simultaneous to the formation of this reservoir 2, the surface of the rod constituting the cathode 1 was coated with zirconium and oxygen.

### (iii) Measurement

Measurements were made using an electron emission property measuring device of the structure shown in Fig. 3. As shown in Fig. 3, the tip of the rod constituting the cathode 1 was positioned between the suppressor electrode 8 and the extractor electrode 9. The distance between the tip of the rod constituting the cathode 1 and the suppressor electrode 8 was 0.10 mm, the distance between the suppressor electrode 8 and the extractor electrode 9 was 0.8 mm, the hole diameter of the extractor electrode 9 was 0.8 mm and the hole diameter of the suppressor electrode 8 was 0.6 mm. A fluorescent material was applied to a screen electrode to form a phosphor screen 10, enabling the electron emission distribution pattern to be observed by eye.

As shown in Fig. 3, the filament 3 was connected to a cathode high voltage power source 16, the cathode high voltage power source 16 as connected to a filament heating power source 14, and a high negative voltage (emitter voltage Vₑₓ) was applied to the extractor electrode 9. The suppressor electrode 8 was connected to a bias power source 15 functioning as a suppressor power source, and a negative suppressor voltage V_{b} was further applied to the rod 1. As a result, the emission of thermal electrons from the filament 3 was blocked.

By applying electricity to the filament 3, the rod constituting the cathode 1 was heated to 1500-1900 K, as a result of which an emission electron beam 17 was emitted from the electron emitting portion at the tip portion of the rod forming the cathode 1. The emitted electron beam 17 was passed through a hole in the extractor electrode 9 to reach a phosphor screen 10 consisting of a screen electrode having an aperture 11 (hole) in the center.

When making the measurements, the inside of the measuring device was set to an ultrahigh vacuum of 3 × 10⁻¹⁰ Torr (4 × 10⁻⁸ Pa), and while keeping the rod 1 at 1800 K, a voltage was applied to the suppressor electrode 8 to obtain a suppressor voltage Vb = -300 V with respect to the rod constituting the cathode 1, then a high voltage was applied to the rod constituting the cathode 1 to achieve an emitter voltage Vex = -4000 V which was maintained for several hours to stabilize the emission current.

### (iv) Measurement of Total Emission Current It of Electron Source

The total emission current It from the electron source was measured by a current meter (not shown) placed between the cathode high voltage source 16 and ground.

### (v) Measurement of Emitter Voltage Vₑₓ Dependence of Probe Current Iₚ (Angular Current Density)

The probe current Iₚ passing through the aperture 11 and reaching the cup-shaped electrode 12 was measured by a microcurrent meter 13 for measuring the probe current.

### (vi) Measurement of Emission Current Distribution of Electron Source

Defining the solid angle computed from the distance between the aperture 11 and the tip of the rod constituting the cathode 1, and the inner diameter of the aperture 11 as ω, the angular current density is Iₚ/ω. Additionally, the aperture 11 and the cup-shaped electrode 12 can be moved from outside the vacuum system, to measure the current emission distribution.

Fig. 6 shows the current emission distribution taking the emission angle on the X axis and the angular current density Iₚ' when Vex = -4000 V on the Y axis. Fig. 6 is the emission current distribution converted to angular current density on the rod constituting the cathode 1 consisting of the shape shown in Fig. 4(b) provided in the electron source described in Example 2.

### <Comparative Example 2>

As a comparative example, an electron source with the processing scar layer removed by electrolytic polishing was produced. A similar rectangular parallelepiped of 2 mm × 0.4 mm × 0.4 mm aligned with the <100> orientation was cut out and worked to the shape shown in Fig. 4(a) by means of mechanical polishing, and an electron emitting portion 7 was provided on the vertex (Fig. 4(b)). The total angle of the vertex of the conical portion 6 was 90°, and the diameter of the electron emission portion 9 was 40 µm.

After mechanical polishing, the processing scar layer was removed by electrolytic polishing. As the conditions for the electrolytic polish, the conical portion 6 of the cathode 1 was immersed in a 1 mol/L aqueous solution of sodium hydroxide, and a voltage of 6 V was applied for 10 seconds between the conductive terminal 4 and an electrode provided in the solution for chemical etching.

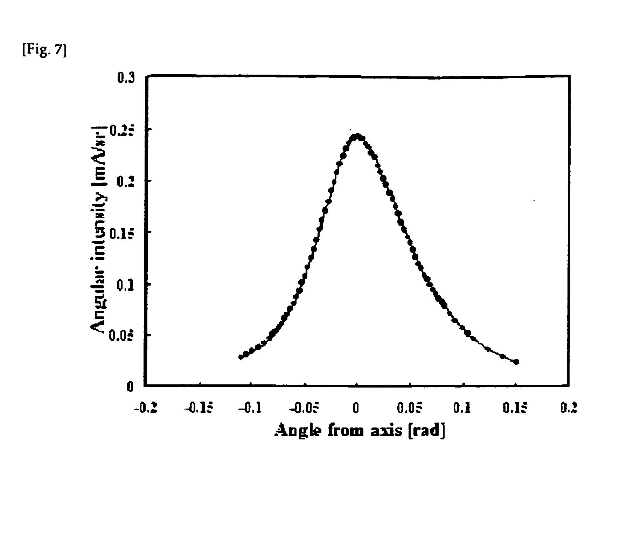

Fig. 7 shows the current distribution with the emission angle on the X axis and the angular current density Iₚ' when Vₑₓ = -4000 V on the Y axis. Fig. 7 is the emission current distribution converted to angular current density on the rod constituting the cathode 1 consisting of the shape shown in Fig. 4(b) provided in the electron source described in Comparative Example 2.

### <Analysis of Results of Example 2 and Comparative Example 2>

The electron source of Example 2 and the electron source of Comparative Example 2, as shown in Figs. 6 and 7, both have a uniform emission current distribution. However, in Fig. 7 showing Comparative Example 2, the angular current density was low. The reason is that electrolytic polishing causes sagging at the outer periphery of the electron emission surface, so that when the diameter of the top surface of the truncated cone which is the electron emission surface is small, the electron emission surface becomes curved, thus reducing the emission current density.

That is, in the method for producing an electron source according to Example 2, vapor phase etching was performed after mechanical polishing, enabling a flattened portion 7 (electron emission surface) with a reduced scar layer and little sagging at the outer periphery to be formed in a short period of time, as a result of which a smooth and even distribution was observed, while obtaining a high angular current density of at least 2 mA/sr. In other words, it was able to achieve a good balance between three technical demands which have a conflicting relationship, the demands being those of (1) efficiently forming an electron emission surface with a reduced scar layer in a short time in an electron source, (2) improving the non-uniformity of current emission distribution, and (3) increasing the emission current density.

The present invention has been explained by means of example 1 above. Modifications are possible within the scope of the present invention as defined in the appended claims.

### Industrial Applicability

An electron gun provided with an electron source produced by the method of producing an electron source according to the present invention is a highly reliable electron gun having a uniform current emission distribution and operating with a large current, so it is suitable for use as an electron gun requiring large currents such as electron beam lithography apparatus, wafer inspection apparatus and electron beam LSI testers, and is extremely useful to industry.

## Claims

1. A method of manufacturing an electron source (1) having an electron emission portion at one tip portion of a rod, the method of manufacturing the electron source comprising:
a step of forming the tip portion in the shape of a truncated cone having a flattened top surface (7) by a machining process,
a step of removing a surface layer of the flattened top surface (7) by focused ion beam processing, and
between the step of forming the tip portion in the shape of a truncated cone and the step of removing a surface layer of the flattened top surface (7) by focused ion beam processing, a step of removing a processing scar layer on the surface of said tip portion by means of vapor phase etching or electrolytic polishing.

2. The method of manufacturing an electron source according to claim 1, wherein said step of removing a surface layer of the flattened top surface (7) is a step of removing the surface layer of the flattened top surface (7) by irradiating with a focused gallium ion beam in an atmosphere of xenon difluoride gas.

3. The method of manufacturing an electron source according to claim 1, wherein the diameter of said flattened top surface (7) is at least 10 µm and at most 100 µm.

4. The method of manufacturing an electron source according to claim 1, wherein said electron source is an electron source obtained by providing a reservoir (2) for diffusion of oxides of a metal element to a monocrystalline rod of tungsten or molybdenum in the <100> orientation.

5. The method of manufacturing an electron source according to claim 4, wherein said metal element is chosen from among Ca, Sr, Ba, Sc, Y, La, Ti, Zr, Hf and the lanthanoids.

## Patentansprüche

1. Verfahren zur Herstellung einer Elektronenquelle (1) mit einem Elektronenemissionsbereich an einem Bereich einer Spitze eines Stabs, wobei das Verfahren zur Herstellung der Elektronenquelle umfasst:
einen Schritt, bei dem der Bereich der Spitze gebildet wird in Form eines abgestumpften Konus, der eine flache obere Oberfläche (7) aufweist, mittels eines maschinellen Bearbeitung,
einen Schritt, bei dem eine Oberflächenschicht der flachen oberen Oberfläche (7) mittels eines fokussierten lonenstrahl-Abtragverfahrens entfernt wird, und
zwischen dem Schritt, bei dem der Bereich einer Spitze in Form eines abgestumpften Konus ausgebildet, wird und dem Schritt, in dem eine Oberflächenschicht der flachen oberen Oberfläche (7) mittels eines fokussierten Ionenstrahl-Abtragverfahrens entfernt wird, ein Schritt, bei dem eine vernarbte Bearbeitungsschicht auf der Oberfläche des Bereichs der Spitze mittels Dampfphasen-Ätzen oder elektrolytischem Polieren entfernt wird.

2. Das Verfahren zur Herstellung einer Elektronenquelle gemäß Anspruch 1, worin der Schritt, bei dem eine Oberflächenschicht der flachen oberen Oberfläche (7) entfernt wird, ein Schritt ist, bei dem die Oberflächenschicht der flachen oberen Oberfläche (7) mittels Anregen mit einem fokussiertem Galliumionenstrahl in einer Atmosphäre aus Xenondifluoridgas entfernt wird.

3. Das Verfahren zur Herstellung einer Elektronenquelle gemäß Anspruch 1, worin der Durchmesser der flachen oberen Oberfläche (7) mindestens 10 µm und höchstens 100 µm beträgt.

4. Das Verfahren zur Herstellung einer Elektronenquelle gemäß Anspruch 1, worin die Elektronenquelle eine Elektronenquelle ist, die durch Bereitstellen eines Reservoirs (2) zur Diffusion von Oxiden eines Metallelements zu einem einkristallinen Stab aus Wolfram oder Molybdän in der <100>-Orientierung erhalten wird.

5. Das Verfahren zur Herstellung einer Elektronenquelle gemäß Anspruch 4, worin das Metallelement ausgewählt ist aus Ca, Sr, Ba, Sc, Y, La, Ti, Zr, Hf und den Lanthanoiden.

## Revendications

1. Procédé de fabrication d'une source d'électrons (1) comportant une partie d'émission d'électrons au niveau d'une partie de pointe d'une tige, le procédé de fabrication de la source d'électrons comprenant :
une étape de formation de la partie de pointe sous la forme d'un tronc de cône présentant une surface supérieure aplatie (7) au moyen d'un traitement d'usinage,
une étape d'élimination d'une couche de surface de la surface supérieure aplatie (7) par un traitement avec un faisceau ionique focalisé, et
entre l'étape de formation de la partie de pointe sous la forme d'un tronc de cône et l'étape d'élimination d'une couche de surface de la surface supérieure aplatie (7) par un traitement avec un faisceau ionique focalisé, une étape d'élimination d'une couche de scarification de traitement sur la surface de ladite partie de pointe au moyen d'une gravure en phase vapeur ou d'un polissage électrolytique.

2. Procédé de fabrication d'une source d'électrons selon la revendication 1, dans lequel ladite étape d'élimination d'une couche de surface de la surface supérieure aplatie (7) est une étape d'élimination de la couche de surface de la surface supérieure aplatie (7) par irradiation avec un faisceau d'ions gallium focalisé dans une atmosphère de difluorure de xénon gazeux.

3. Procédé de fabrication d'une source d'électrons selon la revendication 1, dans lequel le diamètre de ladite surface supérieure aplatie (7) est d'au moins 10 µm et d'au plus 100 µm.

4. Procédé de fabrication d'une source d'électrons selon la revendication 1, dans lequel ladite source d'électrons est une source d'électrons obtenue par dotation d'un réservoir (2) pour la diffusion d'oxydes d'un élément métallique à une tige monocristalline de tungstène ou de molybdène dans l'orientation <100>.

5. Procédé de fabrication d'une source d'électrons selon la revendication 4, dans lequel ledit élément métallique est choisi parmi Ca, Sr, Ba, Sc, Y, La, Ti, Zr, Hf et les lanthanoïdes.
